# FASCICULE DE BREVET EUROPEEN

(11) **EP 3 910 353 B1**
(45) Date de publication et mention de la délivrance du brevet: **07.06.2023**
(21) Numéro de dépôt: 21171375.5
(22) Date de dépôt: 29.04.2021
(51) Int. Cl.: G01R 31/34, G01H 1/00, G01R 21/133, G01H 11/06

(54) **PROCÉDÉ DE DÉSAGRÉGATION DE CHARGES UTILISANT UNE SIGNATURE ÉLECTRIQUE**
VERFAHREN ZUR AUFTEILUNG VON LADUNGEN UNTER VERWENDUNG EINER ELEKTRISCHEN SIGNATUR
METHOD FOR BREAKING UP CHARGES USING AN ELECTRICAL SIGNATURE

(30) Priorité: 30.04.2020 FR 2004307
(43) Date de publication de la demande: 17.11.2021
(73) Titulaire: Chauvin Arnoux, 92600 Asnieres-sur-Seine (FR)
(72) Inventeur: ETIEN, Erik, 92600 ASNIERES-SUR-SEINE (FR); RAMBAULT, Laurent, 92600 ASNIERES-SUR-SEINE (FR); CAUET, Sébastien, 92600 ASNIERES-SUR-SEINE (FR); DOGET, Thierry, 92600 ASNIERES-SUR-SEINE (FR)
(74) Mandataire: Cabinet Beau de Loménie

(56) Documents cités:
- EP-A1- 3 618 223
- WO-A1-2013/006742
- JP-A- 2010 288 352
- US-A1- 2010 169 030
- LEHTORANTA J ET AL: "Fault Diagnosis of Induction Motors with Dynamical Neural Networks", SYSTEMS, MAN AND CYBERNETICS, 2005 IEEE INTERNATIONAL CONFERENCE ON, IEEE, PISCATAWAY, NJ, USA, vol. 3, 10 octobre 2005 (2005-10-10), pages 2979-2984, XP010874115, DOI: 10.1109/ICSMC.2005.1571603 ISBN: 978-0-7803-9298-4

## Description

### Domaine Technique

La présente invention se rapporte au domaine de la mesure en milieu industriel de l'usage d'équipements électriques par désagrégation de charges et elle concerne plus particulièrement l'identification de l'usage d'un équipement électrique comprenant un moteur asynchrone couplé à une charge.

### Technique antérieure

US 2010/169030 A1 divulgue l'identification de l'état des moteurs asynchrones couplés à des charges par une analyse de la signature électrique du moteur.

La technique de désagrégation de charges est connue par le brevet US4,858,151 qui divulgue un procédé et un système basé sur la modélisation de la charge par une admittance équivalente. A partir de mesures électriques obtenues pour la fréquence fondamentale du courant d'alimentation (typiquement à 50 ou 60 Hz), le système calcule les puissances actives et réactives, puis en déduit l'admittance équivalente de la charge.

Toutefois, un tel système qui repose sur une approximation linéaire de la charge, s'il peut se justifier en milieu résidentiel ou tertiaire, n'est pas fidèle à la réalité en milieu industriel, notamment en présence d'équipements électriques comprenant des moteurs asynchrones qui sont avant tout des systèmes non-linéaires générateurs d'un ensemble d'harmoniques liées au courant d'alimentation comme aux variations du couple résistant de ces machines dues aux types de charges entraînées par le moteur asynchrone comme aux défauts intrinsèques de ce moteur et de la charge. En outre, cette méthode d'analyse réduite au fondamental et reposant sur un calcul d'admittances est limitée dans le cas des moteurs asynchrones car, dans le cas de moteurs de puissance équivalente, les admittances obtenues risquent d'être très proches.

### Exposé de l'invention

La présente invention a donc pour but principal de pallier cet inconvénient en proposant un procédé d'identification de l'usage d'un équipement électrique comprenant un moteur asynchrone couplé à une charge particulièrement adapté au milieu industriel.

Ce but est atteint par un procédé d'identification de l'usage d'un équipement électrique connecté à un réseau d'alimentation électrique et comprenant un moteur asynchrone couplé à une charge, caractérisé en ce qu'il comprend l'étape consistant à identifier l'usage de l'équipement électrique en comparant une signature électrique de cet équipement avec des signatures électriques enregistrées, la signature électrique enregistrée étant déterminée dans une étape préalable et consistant en un ensemble limité et prédéterminé de fréquences caractéristiques et de leurs harmoniques déterminées à partir des seules informations figurant sur la plaque signalétique du moteur asynchrone et d'un examen visuel de la charge et de son mode de couplage au moteur asynchrone.

Ainsi, en définissant pour chaque équipement un nombre limité mais suffisant de fréquences caractéristiques, on peut exploiter un domaine spectral large contrairement à l'approche harmonique classique qui se limite à une analyse harmonique autour de la fréquence du réseau électrique. Ce procédé permet ainsi de discriminer les charges électriques par le contenu fréquentiel des courants en y recherchant des fréquences particulières obtenues très simplement sans recourir à des processus sophistiqués d'intelligence artificielle.

Avantageusement, l'examen visuel de la charge consiste à déterminer un nombre de pales, un nombre de pistons ou un diamètre de poulie. L'examen visuel du mode de couplage de la charge au moteur asynchrone consiste à déterminer une fréquence de passage d'une courroie ou une fréquence d'engrènement d'un réducteur.

De préférence, l'équipement électrique est typiquement l'un des suivants : un ventilateur, un compresseur, une pompe, un groupe électrogène.

L'invention concerne également un module d'identification de l'usage d'un équipement électrique connecté au réseau d'alimentation électrique et comprenant un moteur asynchrone couplé à une charge, caractérisé en ce qu'il comprend : un module d'acquisition configuré pour obtenir une grandeur électrique à mesurer et la transformer en un signal exploitable, un module de détection d'évènement configuré pour, à partir de ce signal, extraire un instant particulier caractéristique du démarrage de l'équipement électrique, un module d'extraction configuré pour, depuis la détection du démarrage, extraire une portion de durée déterminée du signal, un module de traitement configuré pour obtenir un spectre fréquentiel de la portion de signal ainsi extraite, une base de données configurée pour enregistrer un ensemble de signatures électriques consistant chacune en un ensemble limité et prédéterminé de fréquences caractéristiques et de leurs harmoniques déterminées à partir des seules informations figurant sur la plaque signalétique du moteur asynchrone et d'un examen visuel de la charge et de son mode de couplage au moteur asynchrone, et un module de reconnaissance et d'identification pour comparer le spectre fréquentiel obtenu avec chacune des signatures électriques enregistrées, reconnaître la signature électrique concernée et alors identifier l'équipement électrique comme étant à l'origine de la signature électrique reconnue.

De préférence, le module d'acquisition est un capteur de mesure de courant et le module de traitement comporte une transformée de fourrier rapide pour obtenir le spectre fréquentiel du courant à partir duquel sont extraites les fréquences caractéristiques de l'équipement électrique.

Avantageusement, Les fréquences caractéristiques sont déterminées par une recherche automatique de la composante la plus grande dans une bande de fréquence prédéterminée B = [Fmin, Fmax], F étant la fréquence caractéristique.

De préférence, la bande de fréquence prédéterminée est comprise entre 1 et 2Hz et la portion de signal de durée déterminée est typiquement comprise entre 10s et 1mn.

Avantageusement, le module de traitement est en outre configuré pour procéder à un pré-traitement par l'obtention d'une moyenne sur N spectres fréquentiels extraits.

### Brève description des dessins

D'autres caractéristiques et avantages de la présente invention ressortiront de la description faite ci-dessous, en référence aux dessins annexés qui en illustrent un exemple de réalisation dépourvu de tout caractère limitatif et sur les lesquels :
[Fig. 1] la figure 1 illustre un schéma de principe du système de désagrégation de charges selon l'invention,
[Fig. 2] la figure 2 montre un exemple de courant relevé sur le réseau électrique au démarrage et après le démarrage d'un équipement électrique,
[Fig. 3] la figure 3 montre le spectre de fréquence du courant illustré à la figure 2,
[Fig. 4] la figure 4 illustre le spectre vibratoire correspondant au spectre du courant de la figure 3, et
[Fig.5] la figure 5 montre les différentes étapes du procédé de l'invention mis en oeuvre dans le système de la figure 1.

### Description des modes de réalisation

La présente invention trouve essentiellement application en milieu industriel où les charges communément rencontrées sont en majorité couplées à des moteurs asynchrones d'équipements électriques tels que des systèmes de ventilation, de compression, de pompage, de climatisation et de production de chaleur ou de froid par exemple.

L'invention repose sur le constat fait par les inventeurs que le spectre électrique d'une charge peut aussi porter les caractéristiques mécaniques de cette charge, comme une vibration particulière. Ainsi, le courant est une onde sinusoïdale 50 Hz modulée en fréquence par les composantes spectrales contenues dans le spectre vibratoire.

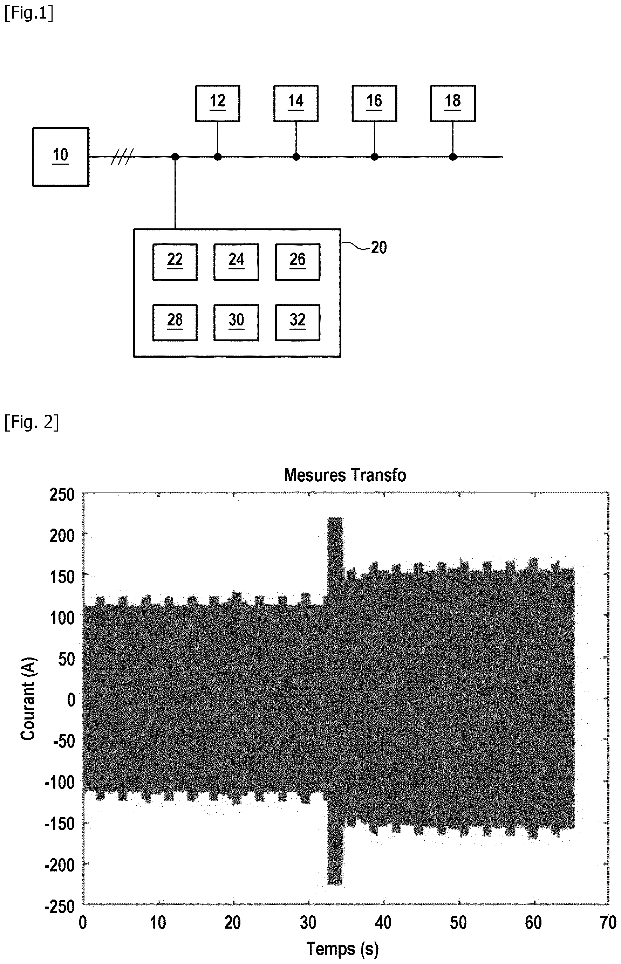

La figure 1 montre de façon schématique un exemple d'un réseau électrique triphasé d'un site industriel avec un transformateur de puissance 10 aux bornes duquel sont reliés par exemple un ventilateur 12, un compresseur 14, une pompe 16 et un groupe électrogène 18. Chacun de ces équipements électriques pourra être couplé directement sur le réseau électrique (démarrage direct ou démarrage électronique puis connexion au réseau) ou au travers d'un variateur, comporte un moteur asynchrone couplé à une charge.

Dans le cas d'un moteur couplé à un variateur, le courant coté moteur sera modulé par les harmoniques recherchées autour de la fréquence fondamentale fournie par le variateur qui peut être variable. Toutefois, en entrée de variateur, le courant sera modulé par les harmoniques recherchées autour de la fréquence fondamentale du réseau électrique (50 Hz ou 60Hz). Ainsi, le type de modulation sera identique (autour de 50hz ou 60hz), que le moteur soit alimenté directement par le réseau ou au travers d'un variateur de vitesse.

Conformément à l'invention, l'identification de l'usage de ces équipements électriques est effectuée dans un module d'identification 20 relié au réseau électrique, de préférence en sortie du transformateur de puissance 10, c'est-à-dire au point de livraison électrique du site industriel au niveau duquel sera réalisé le traitement permettant cette identification.

Le module d'identification est configuré pour séparer différentes contributions des équipements à partir de la mesure de différentes grandeurs électriques, courant ou puissance par exemple, et différentes caractéristiques de ces grandeurs, régime transitoire ou permanent et analyse harmonique.

Pour ce faire, il comporte un module d'acquisition 22 configuré pour obtenir la grandeur électrique à mesurer et la transformer en un signal exploitable, un module de détection d'évènement 24 configuré pour, à partir de ce signal, extraire un instant particulier caractéristique du démarrage (ou de l'arrêt pour la cessation de l'usage) de l'un ou l'autre des équipements connectés au réseau électrique, un module d'extraction 26 configuré pour, depuis la détection de cet instant particulier, extraire une portion de durée déterminée du signal (typiquement compris entre 10s et 1mn) sur lequel portera l'analyse de ce signal, un module de traitement 28 pour obtenir un spectre fréquentiel de la portion de signal ainsi extraite, une base de données 30 comportant l'ensemble des signatures électriques des équipements connectés au réseau électrique, et un module de reconnaissance et d'identification 32 pour comparer le spectre fréquentiel obtenu avec chacune des signatures électriques, reconnaître la signature électrique concernée et alors identifier l'équipement qui est à l'origine de la signature électrique reconnue.

Le module d'acquisition est classiquement un capteur adapté à la grandeur électrique à mesurer, typiquement un transformateur de courant pour une mesure de courant, et les autres modules peuvent être constitués par un unique moyen de traitement numérique de type calculateur ou microprocesseur associés à des moyens logiciels appropriés, la base de données pouvant être constituée par une zone prédéfinie d'une mémoire du microprocesseur ou bien former un module externe du calculateur.

Ce moyen de traitement peut consister par exemple en une transformée de fourrier rapide pour l'obtention du spectre fréquentiel du signal recueilli (des techniques plus élaborées de type zoom FFT sont envisageables pour affiner l'estimation) dans lequel, selon l'invention, il sera recherché des fréquences caractéristiques détaillées plus avant et formant sa signature électrique. Les fréquences recherchées pouvant être noyées dans le bruit, il pourra être nécessaire de procéder à un pré-traitement par l'obtention d'une moyenne sur N spectres recueillis.

En effet, dans un grand nombre de cas, la conversion d'énergie opérée par le moteur électrique asynchrone couplé à la charge s'effectue par différents types de couplage (direct, courroies, réducteur, vis sans fin...) qui vont générer des vibrations en relation d'une part avec les propriétés intrinsèques du moteur : vitesse nominale de rotation et de la charge : nombre de pales pour un ventilateur, nombre de pistons pour un compresseur par exemple, et d'autre part avec le mode de couplage du moteur à la charge : fréquence de passage d'une courroie, fréquence d'engrènement d'un réducteur par exemple.

Ces vibrations vont générer des oscillations du couple résistant autour de sa valeur moyenne, puis une modulation du courant absorbé autour de la fréquence fondamentale du réseau électrique. Selon l'invention, la localisation de ces fréquences caractéristiques dans le courant constituera la signature électrique permettant donc de distinguer et reconnaître chaque équipement.

De même, en pratique, un moteur électrique n'est jamais parfait en termes de construction et de couplage à sa charge et il sera plus ou moins soumis à des défauts : balourd, excentricité, desserrage, désalignement, jeu, roulement défectueux, engrenage endommagé ou usé, fléchissement d'arbre. Comme dans le cas précédent, ces défauts vont générer des vibrations à des fréquences caractéristiques que l'on retrouvera dans le spectre fréquentiel du courant et qui pourront aussi être exploitées pour déterminer la signature électrique.

A titre d'exemple, on s'intéressera à un compresseur à trois pistons de 22KW alimenté depuis un transformateur HTA/BT de 400KVA (fondamental à 50Hz) ayant selon le tableau 1 les caractéristiques suivantes :

**[Table.1]**

| | | |
|---|---|---|
| Vm | Vitesse nominale moteur | 1465 tr/mn |
| Fm | Fréquence nominale moteur | 24.42 Hz |
| Dm | Diam. Poulie moteur | 320mm |
| De | Diam. Poulie compresseur | 440mm |
| R | Rapport de réduction | 0.727 |
| Fc | Fréquence compresseur | 17.76 Hz |

La figure 2 montre le courant relevé par le module d'acquisition 22 sur une phase du transformateur 10. Le compresseur est démarré à t=32s. On enregistre les deux régimes permanents du courant dans une phase entre 0 et 25s (sans compresseur) et entre 40s et 65s (après le démarrage du compresseur). La fréquence d'échantillonnage du signal est Fs=10kHz.

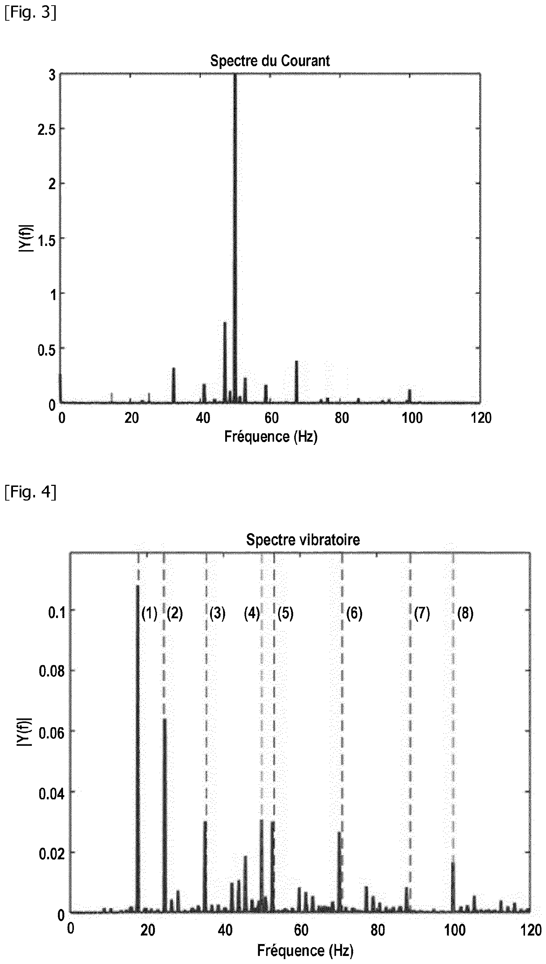

Le spectre du courant absorbé par le compresseur et disponible en sortie du module de traitement 28 est illustré à la figure 3. Il doit être rapproché du spectre du signal vibratoire relevé en régime permanent entre 50s et 65s (correspondant à une résolution fréquentielle Df=1/15=0.064Hz) préalablement par un capteur de vibrations tel qu'un accéléromètre et illustré sur la figure 4 (les valeurs 1 à 8 se rapportent au tableau 2 suivant).

On peut noter dans le tableau 2 suivant la grande similitude des différentes fréquences mesurées dans le spectre de courant par rapport aux valeurs théoriques du spectre vibratoire attendues de ces fréquences :

**[Table.2]**

| | | Grandeur physique | Fréquence théorique (Hz) | Fréquence mesurée (Hz) |
|---|---|---|---|---|
| (1) | Fc | Fréquence compresseur | 17.76 | 17.58 |
| (2) | Fm | Fréquence moteur | 24.42 | 24.6 |
| (3) | 2Fc | 2xFréquence compresseur | 35.52 | 35.13 |
| (4) | Fe | Fréquence réseau | 50 | 49.97 |
| (5) | 3 Fc | 3xFréquence compresseur | 53.28 | 52.71 |
| (6) | 4Fc | 4xFréquence compresseur | 71 | 70.26 |
| (7) | 5Fc | 5xFréquence compresseur | 88.8 | 87.85 |
| (8) | 2Fe | 2xFréquence réseau | 100 | 99.9 |

On peut y noter une composante à la vitesse nominale de rotation du moteur, soit Fm=24.42Hz, une composante à la fréquence du réseau d'alimentation électrique (Fe=50Hz) et ses harmoniques et une composante liée à la charge, soit Fc=17.76Hz et ses harmoniques. En particulier, on pourra noter l'importance des harmoniques de la fréquence du compresseur.

Ces valeurs sont obtenues avantageusement très simplement à partir d'un nombre limité d'informations figurant sur la plaque signalétique du moteur asynchrone dont sa vitesse nominale de rotation et la fréquence du réseau électrique, et un examen visuel de la charge et de son mode de couplage au moteur ou encore par une recherche automatique de la composante la plus grande dans une bande de fréquence donnée B = [Fmin, Fmax] de faible largeur de bande, typiquement 1 à 2Hz. Par exemple, la fréquence moteur correspondant à la vitesse nominale de rotation du moteur est recherchée dans la bande B = [23Hz, 25Hz] (le moteur peut ne pas tourner exactement à sa valeur nominale) et la fréquence compresseur correspondant au produit de la fréquence moteur par le rapport de réduction est quant à elle recherchée dans la bande B = [17Hz, 19Hz] (la fréquence moteur n'est pas exactement la fréquence nominale).

On remarque aussi sur le spectre du courant des composantes qui n'apparaissent pas sur le spectre vibratoire car elles ne sont pas issues des variations du couple résistant, leur origine (harmoniques d'encoche, enroulements, etc...) étant plutôt magnétique et qui toutefois pourraient être exploitables pour enrichir la signature électrique de l'équipement.

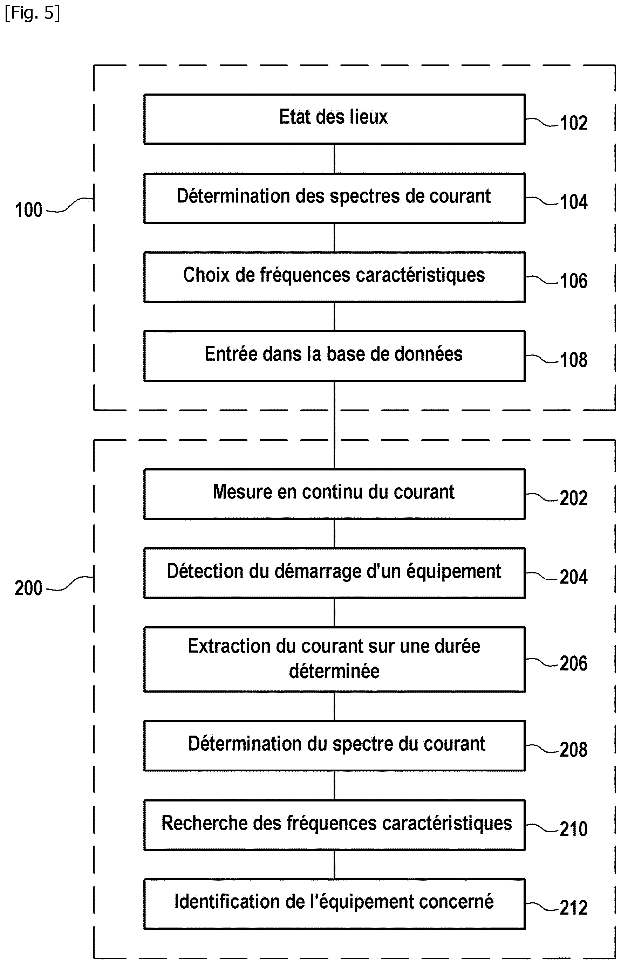

Les différentes étapes du procédé mis en oeuvre dans l'invention sont maintenant illustrées en regard de la figure 5 et se décomposent en une phase d'apprentissage 100 et une phase opérationnelle 200.

La phase d'apprentissage 100 comporte quatre étapes successives consistant dans une première étape 102 en un état des lieux des consommations électriques, dans une deuxième étape 104 en une détermination des spectres des courants de chaque équipement surveillé, dans une troisième étape 106 en un choix dans ces spectres de courant de fréquences caractéristiques et dans une quatrième étape 108 pour chaque équipement surveillé en une entrée des fréquences caractéristiques choisies dans la base de données du module de reconnaissance et d'identification.

L'état des lieux consiste à lister les équipements électriques qui doivent être surveillés par le système et dont on cherche à connaître les usages. La détermination des spectres du courant est effectuée de préférence par une mesure du courant au pied de l'équipement suivie d'un traitement par FFT mais une analyse théorique du processus physique au moyen de sa plaque signalétique et du type de charge entraînée est tout aussi possible et alors très simple à réaliser. Le choix des fréquences caractéristiques qui seront entrées dans la base de données est opéré comme explicité précédemment et repose sur les variations de couple résistant liées à la vitesse de rotation du moteur asynchrone et aux propriétés intrinsèques et de couplage de la charge, comme le nombre de pales pour un ventilateur, le nombre de pistons pour un compresseur, la fréquence de passage d'une courroie ou encore la fréquence d'engrènement d'un réducteur.

La phase opérationnelle 200 comporte quant à elle six étapes consécutives consistant en une mesure (étape 202) en continu du courant relevé sur le réseau électrique effectuée par le module d'acquisition 22, une détection (étape 204) du démarrage d'un équipement sur ce réseau par le module de détection d'évènement 24, un enregistrement (étape 206) du courant sur une durée déterminée par le module d'extraction 26, une détermination (étape 208) du spectre des courants par un calcul FFT au niveau du module de traitement 28, une recherche (étape 210) des fréquences caractéristiques dans la base de données 30, et une identification (étape 212) de l'équipement concerné par le module de reconnaissance et d'identification 32.

On notera que si l'analyse précité a été effectuée sur la mesure d'un seul courant, il est clair pour l'homme du métier qu'elle pourra être étendue à trois courants pour obtenir une représentation vectorielle du courant et faciliter dans ce cas l'emploi de technique de démodulation AM/FM par exemple. De même, elle pourrait aussi être étendue aux courants et tensions afin d'obtenir un spectre de puissance.

## Revendications

1. Procédé d'identification de l'usage d'un équipement électrique (12, 14, 16, 18) connecté à un réseau d'alimentation électrique (10) et comprenant un moteur asynchrone couplé à une charge, **caractérisé en ce qu'**il comprend l'étape consistant à identifier l'usage de l'équipement électrique en comparant une signature électrique de cet équipement avec des signatures électriques enregistrées, la signature électrique enregistrée étant déterminée dans une étape préalable et consistant en un ensemble limité et prédéterminé de fréquences caractéristiques et de leurs harmoniques déterminées à partir des seules informations figurant sur la plaque signalétique du moteur asynchrone et d'un examen visuel de la charge et de son mode de couplage au moteur asynchrone.

2. Procédé selon la revendication 1, **caractérisé en ce que** l'examen visuel de la charge consiste à déterminer un nombre de pales, un nombre de pistons ou un diamètre de poulie.

3. Procédé selon la revendication 2, **caractérisé en ce que** l'examen visuel du mode de couplage de la charge au moteur asynchrone consiste à déterminer une fréquence de passage d'une courroie ou une fréquence d'engrènement d'un réducteur.

4. Procédé selon la revendication 1, **caractérisé en ce que** les informations figurant sur la plaque signalétique du moteur asynchrone incluent la vitesse nominale de rotation du moteur et la fréquence du réseau d'alimentation électrique.

5. Procédé selon l'une quelconque des revendications 1 à 4, **caractérisé en ce que** l'équipement électrique est typiquement l'un des suivants : un ventilateur (12), un compresseur (14), une pompe (16), un groupe électrogène (18).

6. Module d'identification (20) de l'usage d'un équipement électrique (12, 14, 16, 18) connecté au réseau d'alimentation électrique (10) et comprenant un moteur asynchrone couplé à une charge, **caractérisé en ce qu'**il comprend : un module d'acquisition (22) configuré pour obtenir une grandeur électrique à mesurer et la transformer en un signal exploitable, un module de détection d'évènement (24) configuré pour, à partir de ce signal, extraire un instant particulier caractéristique du démarrage de l'équipement électrique, un module d'extraction (26) configuré pour, depuis la détection du démarrage, extraire une portion de durée déterminée du signal, un module de traitement (28) configuré pour obtenir un spectre fréquentiel de la portion de signal ainsi extraite, une base de données (30) configurée pour enregistrer un ensemble de signatures électriques consistant chacune en un ensemble limité et prédéterminé de fréquences caractéristiques et de leurs harmoniques déterminées à partir des seules informations figurant sur la plaque signalétique du moteur asynchrone et d'un examen visuel de la charge et de son mode de couplage au moteur asynchrone, et un module de reconnaissance et d'identification (32) pour comparer le spectre fréquentiel obtenu avec chacune des signatures électriques enregistrées, reconnaître la signature électrique concernée et alors identifier l'équipement électrique comme étant à l'origine de la signature électrique reconnue.

7. Module selon la revendication 6, **caractérisé en ce que** le module d'acquisition est un capteur de mesure de courant et le module de traitement comporte une transformée de fourrier rapide pour obtenir le spectre fréquentiel du courant à partir duquel sont extraites les fréquences caractéristiques de l'équipement électrique.

8. Module selon la revendication 7, **caractérisé en ce que** les fréquences caractéristiques sont déterminées par une recherche automatique de la composante la plus grande dans une bande de fréquence prédéterminée B = [Fmin, Fmax], F étant la fréquence caractéristique.

9. Module selon la revendication 8, **caractérisé en ce que** la bande de fréquence prédéterminée est typiquement comprise entre 1 et 2Hz.

10. Module selon la revendication 6, **caractérisé en ce que** la portion de signal de durée déterminée est typiquement comprise entre 10s et 1mn.

11. Module selon la revendication 6, **caractérisé en ce que** le module de traitement est en outre configuré pour procéder à un pré-traitement par l'obtention d'une moyenne sur N spectres fréquentiels extraits.

## Patentansprüche

1. Verfahren zur Identifizierung des Gebrauchs einer elektrischen Ausrüstung (12, 14, 16, 18), die mit einem Stromversorgungsnetz (10) verbunden ist und einen Asynchronmotor umfasst, der an eine Last gekoppelt ist, **dadurch gekennzeichnet, dass** es den Schritt umfasst, der darin besteht, den Gebrauch der elektrischen Ausrüstung durch Vergleich einer elektrischen Signatur dieser Ausrüstung mit registrierten elektrischen Signaturen zu identifizieren, wobei die registrierte elektrische Signatur in einem vorherigen Schritt bestimmt wird und aus einer begrenzten und vorher festgelegten Gruppe charakteristischer Frequenzen und ihren Harmonischen besteht, die auf der Basis nur der Informationen, die auf dem Maschinenschild des Asynchronmotors stehen und einer visuellen Prüfung der Last und ihres Kopplungsmodus an den Asynchronmotor bestimmt werden.

2. Verfahren nach Anspruch 1, **dadurch gekennzeichnet, dass** die visuelle Prüfung der Last darin besteht, eine Anzahl von Schaufeln, eine Anzahl von Kolben oder einen Scheibendurchmesser zu bestimmen.

3. Verfahren nach Anspruch 2, **dadurch gekennzeichnet, dass** die visuelle Prüfung des Kopplungsmodus der Last mit dem Asynchronmotor darin besteht, eine Passierfrequenz eines Riemens oder einer Eingreiffrequenz eines Getriebes zu bestimmen.

4. Verfahren nach Anspruch 1, **dadurch gekennzeichnet, dass** die Informationen auf dem Maschinenschild des Asynchronmotors die nominale Rotationsgeschwindigkeit des Motors und die Frequenz des Stromversorgungsnetzes einschließen.

5. Verfahren nach einem der Ansprüche 1 bis 4, **dadurch gekennzeichnet, dass** die elektrische Ausrüstung in typischer Weise eine der Folgenden ist: ein Ventilator (12), ein Kompressor (14), eine Pumpe (16), ein Generator (18).

6. Modul zur Identifizierung (20) des Gebrauchs einer elektrischen Ausrüstung (12, 14, 16, 18), die mit einem Stromversorgungsnetz (10) verbunden ist und einen Asynchronmotor umfasst, der an eine Last gekoppelt ist, **dadurch gekennzeichnet, dass** es umfasst: ein Erfassungsmodul (22), das ausgelegt ist, um eine zu messende elektrische Größe zu erhalten und sie in ein verwertbares Signal umzuwandeln, ein Modul zur Ermittlung eines Ereignisses (24), das ausgelegt ist, um ausgehend von diesem Signal einen bestimmten Moment zu extrahieren, der für den Start der elektrischen Ausrüstung charakteristisch ist, ein Extraktionsmodul (26), das ausgelegt ist, um ab der Ermittlung des Starts einen bestimmten Zeitabschnitt des Signals zu extrahieren, ein Verarbeitungsmodul (28), das ausgelegt ist, um ein Frequenzspektrum des derart extrahierten Signalabschnitts zu erhalten, eine Datenbank (30), die ausgelegt ist, um eine Gruppe elektrischer Signaturen zu registrieren, wobei jede aus einer begrenzten und vorher festgelegten Gruppe charakteristischer Frequenzen und ihrer Harmonischen besteht, die nur auf der Basis der Informationen bestimmt werden, die auf dem Maschinenschild des Asynchronmotors stehen und einer visuellen Prüfung der Last und ihres Kopplungsmodus an den Asynchronmotor, und ein Erkennungs- und Identifizierungsmodul (32) zum Vergleichen des mit jeder der registrieren elektrischen Signaturen erhaltenen Frequenzspektrums, Erkennen der entsprechenden elektrischen Signatur und anschließenden Identifizieren der elektrischen Ausrüstung als Ursprung für die erkannte elektrische Signatur.

7. Modul nach Anspruch 6, **dadurch gekennzeichnet, dass** das Erfassungsmodul ein Strommesssensor ist und das Verarbeitungsmodul eine schnelle Fourier-Transformation aufweist, um das Frequenzspektrum des Stroms zu erhalten, auf dessen Basis die charakteristischen Frequenzen der elektrischen Ausrüstung extrahiert werden.

8. Modul nach Anspruch 7, **dadurch gekennzeichnet, dass** die charakteristischen Frequenzen durch eine automatische Suche der größten Komponente in einem vorher festgelegte Frequenzband B = [Fmin, Fmax] bestimmt werden, wobei F die charakteristische Frequenz ist.

9. Modul nach Anspruch 8, **dadurch gekennzeichnet, dass** das vorher festgelegte Frequenzband in typischer Weise zwischen 1 und 2 Hz liegt.

10. Modul nach Anspruch 6, **dadurch gekennzeichnet, dass** der bestimmte Signalzeitabschnitt in typischer Weise zwischen 10 s und 1 min liegt.

11. Modul nach Anspruch 6, **dadurch gekennzeichnet, dass** das Verarbeitungsmodul ferner ausgelegt ist, um eine Vorverarbeitung durch Erhalten eines Mittelwerts über N extrahierte Frequenzspektren durchzuführen.

## Claims

1. Process for identifying the usage of electrical equipment (12, 14, 16, 18) connected to a power supply grid (10) and comprising an asynchronous motor coupled to a charge, **characterized in that** it comprises the step consisting of identifying the usage of electrical equipment by comparing an electrical signature of this equipment with recorded electrical signatures, the recorded electrical signature being determined in a preliminary step and consisting of a limited and predetermined set of characteristic frequencies and their harmonics obtained from the only information featuring on the identification plate of the asynchronous motor and from visual inspection of the charge and its method for coupling to the asynchronous motor.

2. Process according to claim 1, **characterized in that** visual inspection of the charge consists of determining a number of blades, a number of pistons or a pulley diameter.

3. Process according to claim 2, **characterized in that** visual inspection of the coupling method of the charge to the asynchronous motor consists of determining a passing frequency of a belt or a meshing frequency of a reducer.

4. Process according to claim 1, **characterized in that** the information featuring on the identification plate of the asynchronous motor includes the nominal speed of rotation of the motor and the frequency of the power supply grid.

5. Process according to any one of claims 1 to 4, **characterized in that** the electrical equipment is typically one of the following: a fan (12), a compressor (14), a pump (16), a power generator (18).

6. Identification module (20) of the usage of electrical equipment (12, 14, 16, 18) connected to the power supply grid (10) and comprising an asynchronous motor coupled to a charge, **characterized in that** it comprises:
- an acquisition module (22) configured to obtain an electrical magnitude to be measured and transform it into a useable signal,
- an event detection module (24) configured to extract, from said signal, a particular instant characteristic of the start-up of the electrical equipment,
- an extraction module (26) configured to extract, from detection of the start-up, a portion of determined duration of the signal,
- a processing module (28) configured to obtain a frequential spectrum of the portion of signal extracted in this way,
- a database (30) configured to record a set of electrical signatures each consisting of a limited and predetermined set of characteristic frequencies and their harmonics obtained from the only information featuring on the identification plate of the asynchronous motor and from visual inspection of the charge and its method for coupling to the asynchronous motor, and
- a recognition and identification module (32) for comparing the frequential spectrum obtained with each of the recorded electrical signatures, recognising the relevant electrical signature and then identifying the electrical equipment as being at the origin of the recognised electrical signature.

7. Module according to claim 6, **characterized in that** the acquisition module is a current-measuring sensor and the processing module comprises a Fast Fourier Transform to obtain the frequential spectrum of the current from which the characteristic frequencies of the electrical equipment are extracted.

8. Module according to claim 7, **characterized in that** the characteristic frequencies are determined by an automatic search of the largest component in a predetermined frequency band B = [Fmin, Fmax], F being the characteristic frequency.

9. Module according to claim 8, **characterized in that** the predetermined frequency band is typically between 1 and 2 Hz.

10. Module according to claim 6, **characterized in that** the portion of signal of determined duration is typically between 10 s and 1 mn.

11. Module according to claim 6, **characterized in that** the processing module is further configured to carry out pre-processing by obtaining an average over N extracted frequential spectra.
